(19) Europäisches Patentamt
European Patent Office
Office européen des brevets

(11) Veröffentlichungsnummer : **0 064 611**
**B1**

# (12) EUROPÄISCHE PATENTSCHRIFT

(45) Veröffentlichungstag der Patentschrift : **30.07.86**

(51) Int. Cl.⁴ : **H 01 L 23/30**, H 01 B 3/02

(21) Anmeldenummer : **82103193.7**

(22) Anmeldetag : **15.04.82**

## (54) Elektrisch isolierende Einkapselungsmasse für Halbleiteranordnungen.

(30) Priorität : **07.05.81 DE 3118130**

(43) Veröffentlichungstag der Anmeldung : **17.11.82 Patentblatt 82/46**

(45) Bekanntmachung des Hinweises auf die Patenterteilung : **30.07.86 Patentblatt 86/31**

(84) Benannte Vertragsstaaten : **AT DE FR GB IT**

(56) Entgegenhaltungen :
**DE-A- 2 909 815**
**DE-A- 2 946 801**
**GB-A- 2 039 145**
**Chemical Abstracts Band 92, Nr. 6, 11. Februar 1980, Columbus, Ohio, USA G. PERUGINI "Silicon nitride production. On the formation of silicon nitride submicron powders from silicon tetrachloride and ammonia in an arc-plasma furnace", Seite 116, Spalte 1, Abstract Nr. 4395**

(73) Patentinhaber : **Siemens Aktiengesellschaft Berlin und München Wittelsbacherplatz 2 D-8000 München 2 (DE)**

(72) Erfinder : **Pammer, Erich, Dr. Chem. Platanenstrasse 59 D-8028 Taufkirchen (DE)**

**EP 0 064 611 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft eine elektrisch isolierende Einkapselungsmasse für Halbleiteranordnungen bestehend aus einer Mischung eines Harzes und eines anorganischen Füllstoffes.

Entsprechende Einkapselungsmassen zur Umhüllung von Halbleiteranordnungen, wie Einzelhalbleitern oder integrierten Schaltkreisen, sind z. B. aus der DE-PS 17 89 053, der DE-OS 21 48 690 und der DE-OS 21 64 100 bekannt. Als Harze können z. B., wie in der Zeitschrift « Electronikpraxis », Nr. 3/4, 26. März 1968, S. 21-24 beschrieben, Siliconharze oder, wie z. B. aus Circuits Manufacturing, August 1977, S. 29-31 bekannt, Epoxidharze verwendet werden. Als anorganische Füllstoffe kommen z. B. Quarzsand oder Quarzmehl zum Einsatz.

Werden hochintegrierte Schaltkreise, beispielsweise Halbleiterspeicher wie 16 k oder insbesondere 64 k RAM's (Random Access Memories) mit solchen Einkapselungsmassen umhüllt oder mit keramischen Gehäusen versehen, so verursacht der natürliche Anteil an Verunreinigungsspuren von radioaktivem Thorium und Uran in den keramischen Gehäusen bzw. im organischen Füllstoff durch Alphastrahlung induzierte sogenannte « Soft-Error »-Ausfälle.

Diese Ausfälle können — wie aus Electronics, 11. Sept., 1980, S. 41, 42 bekannt — durch eine Bedeckung des Halbleiterchips mittels einer dünnen Silicon- oder Polyimidschicht verhindert werden, da diese Schichten die Energie der von Füllstoff oder Keramikgehäuse kommenden Alphastrahlen hinreichend reduzieren. Eine solche Abdeckung des Halbleiterchips ist jedoch problematisch, da sie sich negativ auf die Dichtigkeit der Bauelementgehäuse und die elektrische Stabilität der Bauelemente auswirken kann. Insbesondere führen die unterschiedlichen Ausdehnungskoeffizienten des Halbleitergrundmaterials (Silicium, Germanium oder eine III-V-Verbindung) und des bedeckenden Filmes leicht zu Kontaktabrissen der den Halbleiterchip und die Anschlußstifte verbindenden Anschlüsse (nail heads etc.).

Aufgabe der Erfindung ist es, hier Abhilfe zu schaffen und eine elektrisch isolierende Einkapselungsmasse für Halbleiteranordnungen zu schaffen, die das Auftreten von « Soft-Error »-Ausfällen bei hochintegrierten Bauelementen verhindert und die Kontaktfestigkeit der Anschlüsse nicht beeinträchtigt.

Diese Aufgabe wird durch eine Einkapselungsmasse der eingangs genannten Art erfindungsgemäß dadurch gelöst, daß der Füllstoff eine aus mindestens einer von Alphastrahlungsquellen weitgehend freien leicht flüchtigen Siliciumhalogenidverbindung hergestellte Siliciumverbindung ausgewählt aus der Gruppe der Siliciumoxide, der Siliciumoxidhydrate und der Siliciumnitride ist oder daß der Füllstoff eine aus einer von Alphastrahlungsquellen weitgehend freien flüchtigen Aluminiumhalogenidverbindung hergestellte Aluminiumverbindung ausgewählt aus der Gruppe der Aluminiumoxide und der Aluminiumoxidhydrate ist. Auf diese Weise gelingt es, eine Einkapselungsmasse zu schaffen, die frei von Alphastrahlung ist, da die zur Herstellung des Füllstoffes verwendeten Siliciumhalogenide bzw. Aluminiumhalogenide erheblich flüchtiger als die entsprechenden Halogenide des Urans und das Thoriums sind und damit von diesen durch bekannte Reinigungsoperationen (Destillation etc.) völlig befreit werden können. Die sonst auftretenden radioaktiven Verunreinigungsspuren im Füllstoff können hierdurch vollständig vermieden werden.

Es liegt im Rahmen der Erfindung, daß die, den Füllstoff bildende Siliciumverbindung durch Hydrolyse oder Oxidation leicht flüchtiger Halogensilane oder durch Umsetzung von Halogensilanen mit Ammoniak ($NH_3$) hergestellt ist und daß als Halogensilane Chlorsilane wie $SiCl_4$, $SiH_2Cl_2$ und $SiHCl_3$ und Fluorsilane, insbesondere Siliciumfluorid ($SiF_4$) verwendet werden. Bei Verwendung einer Aluminiumverbindung als Füllstoff kann diese durch Hydrolyse oder durch Oxidation der flüchtigen Aluminiumhalogenidverbindung hergestellt sein, wobei als Aluminiumhalogenidverbindung bevorzugt Aluminiumchlorid ($AlCl_3$) verwendet wird.

Die zur Herstellung der für die erfindungsgemäßen Einkapselungsmassen benötigten Füllstoffe benötigten Siliciumhalogenidverbindungen können in an sich bekannter Weise durch Einwirkung von Chlor- oder Chlorwasserstoffgas auf Silicium, Siliciumkarbid oder auf ein Gemisch aus $SiO_2$ und Kohle als Chlorsilane wie Siliciumtetrachlorid ($SiCl_4$), Trichlorsilan ($SiHCl_3$) oder $SiH_2Cl_2$ hergestellt werden. Die bei diesem Prozeß entstehenden Chlorsilane sind erheblich flüchtiger als die entsprechenden Chloride des Urans und des Thoriums. So beträgt der Siedepunkt von $SiCl_4$ 57,6 °C, der Siedepunkt von $SiHCl_3$ 33 °C und der Siedepunkt von $SiH_2Cl_2$ + 8,2 °C, während $ThCl_4$ erst bei 820 °C sublimiert und $UCl_4$ einen Siedepunkt von 792 °C aufweist. Die beim Herstellungsprozeß abdestillierenden Chlorsilane sind daher weitgehend frei von Uran- und Thoriumverunreinigungen und können gegebenenfalls durch nochmalige Destillation völlig gereinigt werden. Durch anschließende Hydrolyse bzw. Oxidation der Siliciumchloridverbindungen z. B. gemäß den an sich bekannten Reaktionen

$$SiCl_4 + H_2O \rightarrow SiO_2 \quad [\text{bzw. } SiO(OH)_2] \quad + 4HCl$$
$$SiCl_4 + O_2 \rightarrow SiO_2 + Cl_2 \text{ bzw.}$$
$$SiCl_4 + H_2 + O_2 \rightarrow SiO_2 + 4HCl \text{ } (SiCl_4 \text{ — Hydrolyse in der Knallgasflamme})$$

entstehen alphastrahlungsfreie Siliciumoxide bzw. Siliciumoxidhydrate, die durch nachträgliches Erhitzen auf 600-1 200 °C noch von $H_2O$ und Chloridresten befreit und zu, als Füllstoff geeigneten, $SiO_2$ verdichtet (gesintert) werden.

Bei Verwendung von $SiHCl_3$ und $SiH_2Cl_2$ kann auch unmittelbare Verbrennung des aus einer Düse strömenden Gases in Sauerstoff, z. B. gemäß

$$SiH_2Cl_2 + O_2 \rightarrow SiO_2 + 2HCl$$

erfolgen.

Verwendet man als leicht flüchtige Halogenidverbindung Siliciumfluorid ($SiF_4$), so kann dieses bekanntlich durch Einwirkung von Fluor- oder Fluorwasserstoffgas bzw. Fluorwasserstoffsäure auf Silicium, Siliciumkarbid, ein Gemisch aus $SiO_2$ und Kohle oder gemäß

$$SiO_2 + 4HF \rightarrow SiF_4 \uparrow + 2H_2O$$

durch Einwirkung von Flußsäure bzw. Fluorwasserstoffgas auf natürlich vorkommendes $SiO_2$, wie beispielsweise Quarzsand oder Diatomeenerde, gewonnen werden. Das entstehende gasförmige Siliciumfluorid wird kondensiert und ist, da es leichter flüchtig ist als die entsprechenden Fluoride des Urans und des Thoriums z. B. durch fraktionierte Destillation von diesen Verunreinigungen leicht zu reinigen. So beträgt der Siedepunkt von $SiF_4$ — 86 °C, der Siedepunkt von $UF_6$ + 56 °C, $ThF_4$ ist selbst bei 900 °C noch kaum flüchtig. Zur Herstellung der $SiO_2$ — bzw. Siliciumoxidhydrat — Füllstoffe durch Hydrolyse bzw. Oxidation gilt das bezüglich der Herstellung aus einer Siliciumchloridverbindung Gesagte entsprechend.

Werden die Halogensilane mit Ammoniak ($NH_3$) entweder gleich bei erhöhter Temperatur (600-1 100 °C) umgesetzt oder bei Umsetzung bei 20-600 °C noch anschließend gesintert (900-1 000 °C), so entstehen Siliciumnitride, vorzugsweise $Si_3N_4$, die ebenfalls als strahlungsfreie Sinterstoffe gut geeignet sind.

Verwendet man als Füllstoff ein Aluminiumoxid oder Aluminiumhydroxid, so kann man in an sich bekannter Weise z. B. Aluminiumchlorid ($AlCl_3$) durch Erhitzen von Aluminium im Chlorwasserstoffstrom oder durch Einwirkung von Phosgen ($COCl_2$) auf Tonerde im Wirbelreaktor erzeugen und, da Aluminiumchlorid bereits bei 183 °C sublimiert, in einfacher Weise von den entsprechenden Chloriden des als Verunreinigung im Ausgangsmaterial enthaltenen Urans und des Thoriums trennen. In an sich bekannter Weise, z. B. durch Hydrolyse können aus dem Aluminiumchlorid Aluminiumoxide oder Aluminiumhydroxide als alphastrahlenfreie Füllstoffe hergestellt werden.

Zur Herstellung der erfindungsgemäßen Einkapselungsmasse kann — wie in der DE-OS 21 64 100 beschrieben — dem alphastrahlenfreien Füllstoff ein dünnflüssiges Harz beigemengt werden, welches beispielsweise zur Herstellung von Preßmassen in vorpolymerisiertem Zustand vorliegt. Die dadurch entstehende Masse wird erwärmt um zu entgasen, anschließend zur Umwandlung in einen glasartigen harten Zustand stark gekühlt und danach zur dosierten Weiterverarbeitung zu Pulver oder Granulat zermahlen. Die Einkapselung von Halbleiterkörpern mittels Preßformen erfolgt dann beispielsweise derart, daß die in einen Behälter eingebrachte körnige Einkapselungsmasse in diesem bis zur Plastifizierung erwärmt und unter Druck dosiert in die Form gepreßt wird und bei entsprechender Temperatur der Form aushärtet. Zur Verbesserung der Eigenschaften der Einkapselungsmasse können dem Füllstoff oder dem Harz weitere Zusatzstoffe bzw. Additive zugegeben werden.

Harze und Zusatzstoffe können auch in bekannter Weise unter Zugabe von härtenden und die Polymerisation auslösenden oder beschleunigenden Substanzen zu Gießmassen zum Einbetten von Bauteilen durch Vergießen verarbeitet werden.

Der Anteil der Füllstoffe, die unter anderem aus wirtschaftlichen und thermischen Gründen benötigt werden, an der erfindungsgemäßen Einkapselungsmasse beträgt vorteilhafterweise 60-80 %.

Als erfindungsgemäße Einkapselungsmasse können Niederdruckpreßmassen auf der Basis von Epoxiden, Bisphenol A-Harzen, Novulackharzen oder Siliconen verwendet werden. Entsprechende Epoxidpreßmassen entstehen z. B. durch Zumischen der Füllstoffe zu einem Bisphenol A-Härter-Gemisch, das aus vier Teilen Bisphenol A und einem Teil Härter besteht. Siliconpreßmassen sind durch Zumischen des Füllstoffes zu nur teilvernetzten Siliconen herstellbar.

Die Herstellung einer Niederdruck-Preßmasse zum Umhüllen von elektronischen Bauelementen nach dem Transfer-Preßverfahren, die aus einem nachgereinigten auf Bisphenol A-Basis aufgebauten Epoxidharz besteht, ist ferner in der DE-PS 17 89 053 und der DE-OS 21 48 690 beschrieben.

**Patentansprüche**

1. Elektrisch isolierende Einkapselungsmasse für Halbleiteranordnungen bestehend aus einer Mischung eines Harzes und eines anorganischen Füllstoffes, dadurch gekennzeichnet, daß der Füllstoff eine aus mindestens einer von Alphastrahlungsquellen weitgehend freien leicht flüchtigen Siliciumhalogenidverbindung hergestellte Siliciumverbindung ausgewählt aus der Gruppe der Siliciumoxide, der Siliciumoxidhydrate und der Siliciumnitride ist.

2. Einkapselungsmasse nach Anspruch 1, dadurch gekennzeichnet, daß die Siliciumverbindung durch Hydrolyse leicht flüchtiger Halogensilane hergestellt ist.

3. Einkapselungsmasse nach Anspruch 1, dadurch gekennzeichnet, daß die Siliciumverbindung durch Oxidation leicht flüchtiger Halogensilane hergestellt ist.

4. Einkapselungsmasse nach einem der Ansprüche 1 bis 3, dadurch gekennzeichnet, daß die Siliciumverbindung durch Umsetzung von Halogensilanen mit Ammoniak ($NH_3$) hergestellt ist.

5. Einkapselungsmasse nach einem der Ansprüche 1 bis 4, dadurch gekennzeichnet, daß die Siliciumverbindung aus einem Siliciumchlorid hergestellt ist.

6. Einkapselungsmasse nach einem der Ansprüche 1 bis 4, dadurch gekennzeichnet, daß die Siliciumverbindung aus einem Siliciumfluorid hergestellt ist.

7. Einkapselungsmasse nach einem der Ansprüche 1 bis 6, dadurch gekennzeichnet, daß die aus einer Siliciumhalogenidverbindung hergestellte Siliciumverbindung durch Erhitzen auf 600-1 200 °C, insbesondere 1 000 °C, verdichtet ist.

8. Elektrisch isolierende Einkapselungsmasse für Halbleiteranordnungen bestehend aus einer Mischung eines Harzes und eines anorganischen Füllstoffes, dadurch gekennzeichnet, daß der Füllstoff eine aus einer von Alphastrahlungsquellen weitgehend freien flüchtigen Aluminiumhalogenidverbindung hergestellte Aluminiumverbindung ausgewählt aus der Gruppe der Aluminiumoxide und der Aluminiumhydroxide ist.

9. Einkapselungsmasse nach Anspruch 8, dadurch gekennzeichnet, daß die Aluminiumverbindung durch Hydrolyse der flüchtigen Aluminiumhalogenidverbindung hergestellt ist.

10. Einkapselungsmasse nach Anspruch 8, dadurch gekennzeichnet, daß die Aluminiumverbindung durch Oxidation der flüchtigen Aluminiumhalogenidverbindung hergestellt ist.

11. Einkapselungsmasse nach einem der Ansprüche 8 bis 10, dadurch gekennzeichnet, daß die Aluminiumverbindung aus einem Aluminiumchlorid hergestellt ist.

## Claims

1. An electrically-insulating encapsulating material for semiconductor arrangements, consisting of a mixture of a resin and an inorganic filler, characterised in that the filler is a silicon compound, produced from at least one readily volatile silicon halide which is substantially free from alpha-radiation sources, selected from the group of silicon oxides, silicon oxide hydrates and silicon nitrides.

2. An encapsulating material as claimed in Claim 1, characterised in that the silicon compound is produced by the hydrolysis of readily volatile halosilanes.

3. An encapsulating material as claimed in Claim 1, characterised in that the silicon compound is produced by the oxidation of readily volatile halosilanes.

4. An encapsulating material as claimed in one of Claims 1 to 3, characterised in that the silicon compound is produced by the reaction of halosilanes with ammonia ($NH_3$).

5. An encapsulating material as claimed in one of Claims 1 to 4, characterised in that the silicon compound is produced from a silicon chloride.

6. An encapsulating material as claimed in one of the Claims 1 to 4, characterised in that the silicon compound is produced from a silicon fluoride.

7. An encapsulating material as claimed in one of Claims 1 to 6, characterised in that the silicon compound which is produced from a silicon halide is consolidated by heating to 600-1 200 °C, in particular 1 000 °C.

8. An electrically-insulating encapsulating material for semiconductor arrangements, consisting of a mixture of a resin and an inorganic filler, characterised in that the filler is an aluminium compound produced from a volatile aluminium halide which is substantially free from alpha-radiation sources, selected from the group aluminium oxides and aluminium hydroxides.

9. An encapsulating material as claimed in Claim 8, characterised in that the aluminium compound is produced by hydrolysis of the volatile aluminium halide.

10. An encapsulating material as claimed in Claim 8, characterised in that the aluminium compound is produced by oxidation of the volatile aluminium halide.

11. An encapsulating material as claimed in one of Claims 8 to 10, characterised in that the aluminium compound is produced from an aluminium chloride.

## Revendications

1. Masse d'encapsulage électriquement isolante pour des dispositifs à semi-conducteurs, constituée par un mélange d'une résine et d'une matière de remplissage anorganique, caractérisée par le fait que la matière de remplissage est un composé du silicium du groupe des oxydes du silicium, des hydrates de silicium et des nitrures du silicium préparé à partir d'au moins un halogénure de silicium très volatil et largement dépourvu de sources de rayonnement alpha.

2. Masse d'encapsulage selon la revendication 1, caractérisée par le fait que le composé du silicium est préparé par hydrolyse d'halogénures de silanes très volatils.

3. Masse d'encapsulage selon la revendication 1, caractérisée par le fait que le composé du silicium est préparé par oxydation d'halogénures de silanes très volatils.

4. Masse d'encapsulage selon l'une des revendications 1 à 3, caractérisée par le fait que le composé du silicium est préparé par réaction d'halogénures de silanes avec de l'ammoniac ($NH_3$).

5. Masse d'encapsulage selon l'une des revendications 1 à 4, caractérisée par le fait que le composé du silicium est préparé à partir d'un chlorure de silicium.

6. Masse d'encapsulage selon l'une des revendications 1 à 4, caractérisée par le fait que le composé de silicium est préparé à partir d'un fluorure de silicium.

7. Masse d'encapsulage selon l'une des revendications 1 à 6, caractérisée par le fait que le composé du silicium qui est préparé à partir d'un composé d'halogénure de silicium est densifié par chauffage à 600-1 200 °C, en particulier à 1 000 °C.

8. Masse d'encapsulage électriquement isolante pour des dispositifs à semi-conducteurs, constituée par un mélange d'une résine et d'une matière de remplissage anorganique, caractérisée par le fait que la matière de remplissage est constituée par un composé d'aluminium, choisi dans le groupe des oxydes d'aluminium et des hydroxydes d'aluminium, préparé à partir d'un halogénure d'aluminium très volatil et très largement dépourvu de sources de rayonnement alpha.

9. Masse d'encapsulage selon la revendication 8, caractérisée par le fait que le composé d'aluminium est préparé par hydrolyse de l'halogénure d'aluminium volatil.

10. Masse d'encapsulage selon la revendication 8, caractérisée par le fait que le composé d'aluminium est préparé par oxydation du composé d'halogénure d'aluminium volatil.

11. Masse d'encapsulage selon l'une des revendications 8 à 10, caractérisée par le fait que le composé d'aluminium est préparé à partir d'un chlorure d'aluminium.